(19)

**Europäisches Patentamt**
**European Patent Office**
**Office européen des brevets**

(11)  **EP 4 462 973 B1**

(12)  **EUROPEAN PATENT SPECIFICATION**

(45) Date of publication and mention
of the grant of the patent:
**14.01.2026  Bulletin 2026/03**

(51) International Patent Classification (IPC):
**H10K 10/10** *(2023.01)*     **H01G 9/20** *(2006.01)*

(52) Cooperative Patent Classification (CPC):
**H10K 10/10; H01G 9/2027;** Y02E 60/13

(21) Application number: **24460020.1**

(22) Date of filing: **06.05.2024**

(54) **INTEGRATED PHOTOELECTROCHEMICAL CAPACITOR AND METHOD FOR OBTAINING AN INTEGRATED PHOTOELECTROCHEMICAL CAPACITOR**

INTEGRIERTER PHOTOELEKTROCHEMISCHER KONDENSATOR UND VERFAHREN ZUR HERSTELLUNG EINES INTEGRIERTEN PHOTOELEKTROCHEMISCHEN KONDENSATORS

CONDENSATEUR PHOTOÉLECTROCHIMIQUE INTÉGRÉ ET MÉTHODE D'OBTENTION D'UN CONDENSATEUR PHOTOÉLECTROCHIMIQUE INTÉGRÉ

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority:  **08.05.2023  PL 44479023**

(43) Date of publication of application:
**13.11.2024  Bulletin 2024/46**

(73) Proprietor: **Politechnika Gdanska**
**80-233 Gdansk (PL)**

(72) Inventors:
- **SZKODA, Mariusz**
**80-233 Gdansk (PL)**
- **TRZCINSKI, Konrad**
**80-233 Gdansk (PL)**
- **RODA, Daria**
**80-233 Gdansk (PL)**
- **ZARACH, Zuzanna**
**80-233 Gdansk (PL)**

(74) Representative: **Pawlowska-Bajerska, Justyna**
**Gdansk University of Technology**
**ul. G. Narutowicza 11/12**
**80-233 Gdansk (PL)**

(56) References cited:
- **JUODKAZYTE J ET AL: "Light energy accumulation using Ti/RuO2 electrode as capacitor", JOURNAL OF SOLID STATE ELECTROCHEMISTRY ; CURRENT RESEARCH AND DEVELOPMENT IN SCIENCE AND TECHNOLOGY, SPRINGER, BERLIN, DE, vol. 14, no. 5, 29 April 2009 (2009-04-29), pages 741 - 746, XP019762806, ISSN: 1433-0768**
- **TRZCINSKI K ET AL: "Enhanced photoelectrochemical performance of inorganic-organic hybrid consisting of BiVO4and PEDOT:PSS", APPLIED SURFACE SCIENCE,, vol. 388, 18 February 2016 (2016-02-18), pages 753 - 761, XP029750075, DOI: 10.1016/ J.APSUSC.2016.02.143**
- **QUEYRIAUX NICOLAS ET AL: "Molecular cathode and photocathode materials for hydrogen evolution in photoelectrochemical devices", JOURNAL OF PHOTOCHEMISTRY, ELSEVIER, AMSTERDAM, NL, vol. 25, 7 August 2015 (2015-08-07), pages 90 - 105, XP029332964, ISSN: 1389-5567, DOI: 10.1016/ J.JPHOTOCHEMREV.2015.08.001**
- **KASEM KASEM K. ET AL: "Photoelectrochemical Studies on High Specific Capacitance-Photoactive Interfaces Based on Poly 3,4-Ethylenedioxythiophene/Metal Oxides Assemblies", JOURNAL OF MATERIALS SCIENCE AND CHEMICAL ENGINEERING, vol. 03, no. 05, 1 January 2015 (2015-01-01), Irvine, Calif., USA, pages 88 - 97, XP093220451, ISSN: 2327-6045, DOI: 10.4236/msce.2015.35010**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 462 973 B1

## Description

The invention refers to an integrated photoelectrochemical capacitor according to claim 1 - kind of photocapacitor enabling both energy conversion and energy storage, as well as a method for manufacturing an integrated photoelectrochemical capacitor according to claim 2.

Photoelectrochemical capacitors, also known as PEC capacitors, are innovative devices that enable both photoelectric conversion and energy storage. These two functions are achieved by irradiating a semiconductor electrode with sunlight and adsorbing ions. It is expected that photoelectrochemical capacitors will be applied in portable devices.

Miyasaka et al. in their work "A high-voltage dye-sensitized photocapacitor of a three-electrode system" (Chem. Commun. (2005), pp. 3346-3348) developed a three-electrode PEC capacitor, where mesoporous $TiO_2$ sensitized with dye and activated carbon enable energy conversion and storage, respectively.

Takahashi and Tatsuma in their work "Visible light-induced photocatalysts with reductive energy storage abilities" (Electrochem. Commun., 10 (2008), pp. 1404-1407) reported that a system consisting of a $TiO_2$ electrode for energy conversion and a WO3 electrode for energy storage could be successfully applied to PEC capacitors.

Joudkazytė et al. in their work "Light energy accumulation using Ti/$RuO_2$ electrode as capacitor" (J. Solid State Electrochem., 14 (2010), pp. 741-746) developed PEC capacitors utilizing two electrodes: a $TiO_2$ electrode and a $RuO_2$ electrode.

It should be noted that in the aforementioned works, the electrodes for energy conversion and storage are not integrated. It is considered that separate electrodes are disadvantageous due to the space and weight savings of the device.

The aim of the invention was to provide an efficient capacitor for both energy conversion and energy storage. The capacitor structure and its manufacturing method were selected and worked out by selecting appropriate materials for its construction, among other features, parameters.

According to the invention, the integrated photoelectrochemical capacitor is based on - comprises bismuth vanadate ($BiVO_4$) and poly(3,4-ethylenedioxythiophene) (PEDOT). On one side of the capacitor, it comprises a $BiVO_4$ layer, preferably with a thickness ranging from 70 to 1000 nm, deposited on fluorine-doped tin oxide (FTO) conductive glass. On the other side - opposite side of the capacitor, it comprises an electrochemically deposited PEDOT layer on FTO glass. Both FTO glass layers are joined together on the non-conductive side using resin, preferably epoxy, while the conductive sides are connected using known in the state of the art tape.

The provided method for obtaining the integrated photoelectrochemical capacitor based on bismuth vanadate ($BiVO_4$) and poly(3,4-ethylenedioxythiophene) (PEDOT), referred to as PEDOT. The provided method involves - comprising following steps: depositing a $BiVO_4$ layer on - onto fluorine-doped tin oxide (FTO) conductive glass using known techniques - like pulsed laser ablation from a $BiVO_4$ target (tab) - what set the first glass layer, with a thickness of preferably from 70 to 1000 nm. The obtained material undergoes calcination during the sputtering process - coating - in the temperature range of 300 to 600°C. In the next step, subsequently, the PEDOT layer, is electrochemically deposited on - onto another FTO glass - the second glass layer. The electrodeposition process is carried out in an aqueous solution of 3,4-ethylenedioxythiophene (EDOT) with a concentration of 2-20 mM and polystyrene sulfonate (PSS) with a concentration of 20-200 mM, at a charge density of 200-1000 mC/cm$^2$ and under an anodic potential ranging from 0.9 to 1.5 V vs. a reference electrode, preferably sych as Ag/AgCl (3 M KCl) or calomel electrode. In the next step, both FTO glasses containing the selected material layers are bonded - joinded - connected together on the non-conductive side (from said side) using resin, such as epoxy, while the conductive sides are connected - bonded using known tape, such as copper tape.

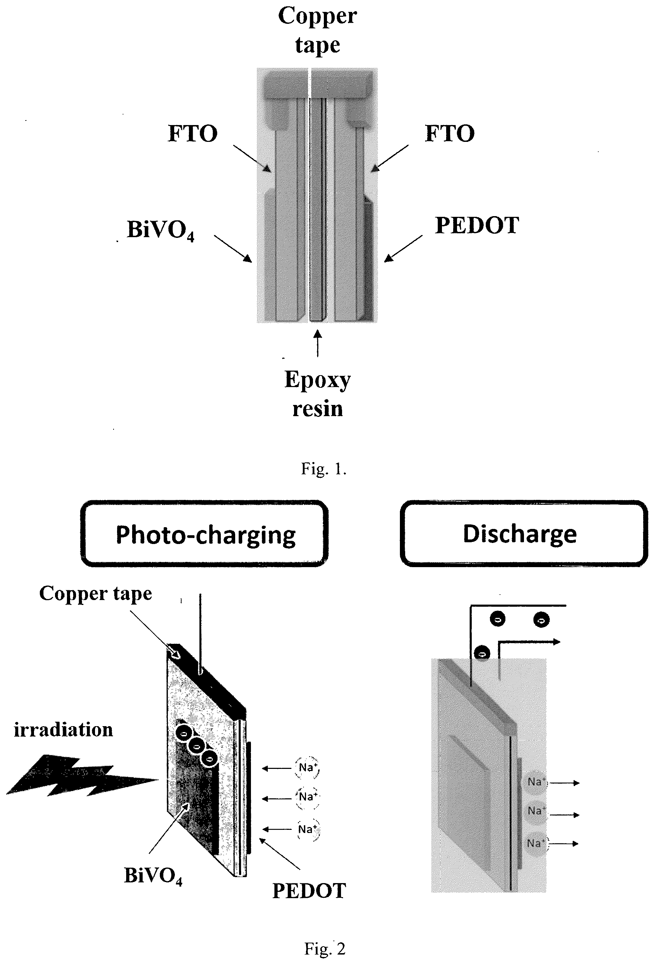

The subject of the invention is illustrated in the exemplary embodiment shown in the figures, where Fig. 1 2 illustrates the assembly diagram of the photoelectrochemical capacitor electrode, its structure, and Fig. 2 illustrates the schematic of photocharging and discharging of the electrochemical capacitor. Fig. 2 demonstrates the charging mechanism, thus illustrating the practical use of the capacitor for charging purposes - effects of the invention.

Example 1

Bismuth vanadate layers are deposited onto conductive and transparent FTO glass in a PLD (Pulsed Laser Deposition) chamber. The material is sputtered from a previously prepared $BiVO_4$ target. The deposition temperature is kept constant at 500°C. The deposition time is 60 minutes, resulting in a layer thickness of 90 nm. PEDOT is electrochemically deposited onto the second FTO glass. The electropolymerization process is conducted in an aqueous solution of EDOT (3,4-ethylenedioxythiophene) with a concentration of 2 mM and 20 mM PSS (polystyrene sulfonate) at a charge density of 400 mC/cm$^2$ and an anodic potential ranging from 1.1 V vs. Ag/AgCl (3 M KCl) reference electrode. The thickness of the polymer layer is approximately 200 nm. The next step involves the integration of the two electrode materials, which consists of bonding the obtained FTO glasses (on the non-conductive side) containing the material layers using epoxy resin. The conductive sides are connected using copper tape.

As shown on fig. 2 - according to Fig. 2, when $BiVO_4$ is exposed to radiation with energy equal to or higher than the bandgap energy, electrons are excited from the valence band to the conduction band, leaving positively charged holes in the valence band. These holes migrate towards the surface and are consumed in the oxidation of water. Photoexcited electrons can accumulate on the surface of both $BiVO_4$ and PEDOT since these two electrodes are connected. The accumulation of electrons lowers the potential of PEDOT, allowing the attraction of $Na^+$ ions from the electrolyte to the electrode surface (charging). The stored sodium ions are held in the electrical double layer of the conducting polymer. If the electrodes are connected to a counter electrode via an external circuit, the photoexcited electrons flow through this circuit, leading to discharging, which involves desorption, and the sodium ions return to the electrolyte.

This example confirms that during illumination with simulated sunlight of the obtained cell, it was possible to charge the capacitor to approximately 0.6 V in about 100 s. Then, the capacitor was discharged at an appropriate current density, with a discharge time of over 100 s. Based on this and using the formula $C = \frac{j \cdot t}{\Delta U}$ the calculated capacitance of the proposed device was approximately 40 mF/cm$^2$.

## Claims

1.  Integrated photoelectrochemical capacitor **characterized in that**, the capacitor is based on bismuth vanadate ($BiVO_4$) and poly(3,4-ethylenedioxythiophene) (PEDOT), while on one side of the capacitor it comprises a $BiVO_4$ layer, preferably with a thickness ranging from 70 to 1000 nm, deposited on fluorine-doped tin oxide (FTO) conductive glass, and on the opposite side it comprises an electrochemically deposited PEDOT layer on FTO glass, wherein both FTO glass layers are connected together on the non-conductive side using resin, preferably epoxy, and the conductive sides are connected using tape.

2.  Method for manufacturing the integrated photoelectrochemical capacitor based on bismuth vanadate ($BiVO_4$) and poly(3,4-ethylenedioxythiophene) (PEDOT) according to claim 1, comprising a step of depositing a $BiVO_4$ layer on fluorine-doped tin oxide (FTO) conductive glass, preferably with a thickness ranging from 70 to 1000 nm, using pulsed laser ablation, while a calcination step during the sputtering process in the temperature range of 300 to 600°C of the obtained material is performed, and next, PEDOT is electrochemically deposited on another FTO glass while the electrodeposition process is conducted in an aqueous solution of the monomer 3,4-ethylenedioxythiophene (EDOT), preferably with a concentration of 2-20 mM and preferably with the addition of polystyrene sulfonate (PSS) with a concentration of 20-200 mM, preferbly at a charge density of 200-1000 mC/cm$^2$, and preferably at an anodic potential ranging from 0.9 to 1.5 V with regards to a reference electrode, and then both FTO glasses comprising the material layers are connected together on the non-conductive side using resin, preferably epoxy, while the conductive sides are connected using tape.

3.  The method according to claim 2, wherein the reference electrode is Ag/AgCl (KCl) or calomel.

4.  The method according to claim 2, wherein the tape is copper.

## Patentansprüche

1.  Integrierter photoelektrochemischer Kondensator, **dadurch gekennzeichnet, dass** der Kondensator auf Wismutvanadat ($BiVO_4$) und Poly(3,4-ethylendioxythiophen) (PEDOT) basiert, wobei der Kondensator auf einer Seite eine $BiVO_4$-Schicht mit einer bevorzugten Dicke von 70 bis 1000 nm umfasst, die auf einem mit Fluor dotierten Zinnoxid (FTO) beschichteten leitfähigen Glas abgeschieden ist, und auf der gegenüberliegenden Seite eine elektrochemisch abgeschiedene PEDOT-Schicht auf FTO-Glas umfasst, wobei beide FTO-Gläser auf ihrer nichtleitenden Seite mittels eines Harzes, vorzugsweise eines Epoxidharzes, miteinander verbunden sind und die leitfähigen Seiten unter Verwendung eines Bandes miteinander verbunden werden.

2.  Verfahren zur Herstellung des integrierten photoelektrochemischen Kondensators auf Basis von Wismutvanadat ($BiVO_4$) und Poly(3,4-ethylendioxythiophen) (PEDOT) nach Ansprüche 1, **dadurch gekennzeichnet, dass** eine $BiVO_4$-Schicht auf einem mit Fluor dotierten Zinnoxid (FTO) beschichteten leitfähigen Glas durch gepulste Laserablation abgeschieden wird, vorzugsweise mit einer Schichtdicke von 70 bis 1000 nm, wobei während des Abscheidungsprozesses eine Kalzinierung des erhaltenen Materials bei einer Temperatur im Bereich von 300 bis 600 °C durchgeführt wird, und dass anschließend PEDOT elektrochemisch auf einem weiteren FTO-Glas abgeschieden wird, wobei der Elektroabscheidungsprozess in einer wässrigen Lösung des Monomers 3,4-Ethylendioxythiophen (EDOT) mit einer Konzentration von vorzugsweise 2 bis 20 mM und unter Zusatz von Polystyrolsulfonat (PSS) mit einer Konzentration von 20 bis 200 mM durchgeführt wird, vorzugsweise bei einer Ladungsdichte von 200 bis 1000 mC/cm$^2$ und einem Anodenpotential von 0,9 bis 1,5 V gegenüber einer Referenzelektrode, und dass anschließend beide FTO-Gläser mit den abgeschiedenen Materialschichten auf ihrer nichtleitenden Seite mittels Harz, vorzugsweise Epoxidharz, miteinander verbunden werden, während die leitfähigen Seiten unter Verwendung eines Bandes verbunden werden.

3. Verfahren nach Ansprüche 1, wobei dass die Referenzelektrode Ag/AgCl (KCl) oder eine Kalomelelektrode ist.

4. Verfahren nach Ansprüche 1, wobei dass das Band aus Kupfer besteht

**Revendications**

1. Condensateur photoélectrochimique intégré, **caractérisé en ce que** le condensateur est basé sur le vanadate de bismuth (BiVO$_4$) et le poly(3,4-éthylènedioxythiophène) (PEDOT), le condensateur comprend, d'un côté, une couche de BiVO$_4$ d'une épaisseur préférée comprise entre 70 et 1000 nm, déposée sur un verre conducteur en oxyde d'étain dopé au fluor (FTO), et, de l'autre côté, une couche de PEDOT déposée électrochimiquement sur un verre FTO, les deux verres FTO étant reliés entre eux du côté non conducteur au moyen d'une résine, de préférence une résine époxy, et les faces conductrices étant connectées à l'aide d'un ruban.

2. Procédé de fabrication du condensateur photoélectrochimique intégré à base de vanadate de bismuth (BiVO$_4$) et de poly(3,4-éthylènedioxythiophène) (PEDOT) selon la revendication 1, **caractérisé en ce qu'**une couche de BiVO$_4$ est déposée sur un verre conducteur en oxyde d'étain dopé au fluor (FTO) par ablation laser pulsée, de préférence avec une épaisseur comprise entre 70 et 1000 nm, une étape de calcination du matériau obtenu étant effectuée pendant le procédé de dépôt à une température comprise entre 300 et 600 °C, et **en ce que** le PEDOT est ensuite déposé électrochimiquement sur un autre verre FTO, le procédé d'électrodéposition étant réalisé dans une solution aqueuse du monomère 3,4-éthylènedioxythiophène (EDOT), de préférence à une concentration comprise entre 2 et 20 mM et avec l'addition préférée de polysulfonate de styrène (PSS) à une concentration de 20 à 200 mM, de préférence à une densité de charge de 200 à 1000 mC/cm$^2$ et à un potentiel anodique compris entre 0,9 et 1,5 V par rapport à une électrode de référence, les deux verres FTO comportant les couches de matériau étant ensuite assemblés sur leur face non conductrice au moyen d'une résine, de préférence une résine époxy, tandis que les faces conductrices sont reliées à l'aide d'un ruban.

3. Procédé selon la revendication 2, **caractérisé en ce que** l'électrode de référence est une électrode Ag/AgCl (KCl) ou une électrode au calomel.

4. Procédé selon la revendication 2, **caractérisé en ce que** le ruban est en cuivre.

**Copper
tape**

FTO          FTO

$BiVO_4$          PEDOT

**Epoxy
resin**

Fig. 1.

**Photo-charging**      **Discharge**

Copper tape

irradiation

$Na^+$
$Na^+$
$Na^+$

$BiVO_4$      PEDOT

$Na^+$
$Na^+$
$Na^+$

Fig. 2

## EP 4 462 973 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **MIYASAKA et al.** A high-voltage dye-sensitized photocapacitor of a three-electrode system. *Chem. Commun.*, 2005, 3346-3348

- **TAKAHASHI ; TATSUMA**. Visible light-induced photocatalysts with reductive energy storage abilities. *Electrochem. Commun.*, 2008, vol. 10, 1404-1407